# FASCICULE DE BREVET EUROPEEN

(11) **EP 4 296 907 B1**
(45) Date de publication et mention de la délivrance du brevet: **25.03.2026**
(21) Numéro de dépôt: 23179388.6
(22) Date de dépôt: 15.06.2023
(51) Int. Cl.: G06N 10/40, B82Y 10/00, H10D 48/00, H10D 64/27

(54) **DISPOSITIF ÉLECTRONIQUE À QUBITS DE SPIN**
ELEKTRONISCHE VORRICHTUNG MIT SPIN-QUBITS
SPIN QUBIT ELECTRONIC DEVICE

(30) Priorité: 23.06.2022 FR 2206266
(43) Date de publication de la demande: 27.12.2023
(73) Titulaire: Commissariat à l'Energie Atomique et aux Energies Alternatives, 75015 Paris (FR)
(72) Inventeur: BAILLIN, Xavier, 38054 Grenoble cedex 09 (FR); FOURNEL, Richard, 38054 Grenoble cedex 09 (FR)
(74) Mandataire: Hautier IP

(56) Documents cités:
- JP-A- 2007 193 778
- US-A1- 2022 083 890

## Description

### DOMAINE TECHNIQUE

La présente invention concerne le domaine de l'électronique quantique. Elle trouve pour application particulièrement avantageuse la réalisation de dispositifs quantiques à bits quantiques (appelés quantum bits ou qubits) permettant d'effectuer des calculs quantiques et/ou des opérations logiques binaires.

### ETAT DE LA TECHNIQUE

Dans le domaine de l'électronique quantique, un bit quantique ou qubit correspond à un état quantique qui représente la plus petite unité de stockage d'information quantique. Cet état quantique est caractérisé par la superposition quantique de plusieurs états, notamment de l'état 0 et de l'état 1. En pratique le bit quantique ou qubit peut être obtenu par différents dispositifs basés sur différentes architectures. Ainsi, il existe des qubits liés à un état quantique :
- d'un porteur de charge, par exemple le spin d'un électron (qubit de spin),
- d'un courant circulant entre deux régions supraconductrices au travers d'une jonction Josephson, par exemple sa phase (qubit supraconducteur),
- d'un ion piégé ou d'un atome ou d'une molécule, par exemple son niveau énergétique,
- d'un photon, par exemple sa polarisation (qubit photonique).

Chaque type de dispositif possède des avantages intrinsèques et des inconvénients distincts. Par exemple, les dispositifs quantiques à qubits supraconducteurs permettent d'obtenir une bonne intrication entre qubits. Le taux d'erreur dans le calcul quantique à partir de qubits supraconducteurs est faible. Cependant, ces qubits supraconducteurs nécessitent un environnement cryogénisé. Le contrôle des qubits supraconducteurs est complexe et coûteux.

Les dispositifs quantiques à qubits de spin présentent au contraire une faible intrication. Leur consommation d'énergie en fonctionnement est faible, et leur fabrication est facilitée par les procédés de la microélectronique. Ces dispositifs quantiques à qubits de spin constituent l'une des voies les plus prometteuses dans le développement de processeurs quantiques.

Il est possible de manipuler l'état de spin (haut et bas) des qubits par la technique de résonance électronique de spin ESR (Electron Spin Resonance). Sous l'action d'un champ magnétique, deux niveaux d'énergie distincts correspondant à deux états de spin opposés apparaissent par effet Zeeman. En exposant alors le qubit à une radiation radiofréquence (RF), il est possible de basculer le qubit d'un état de spin à l'autre, codant typiquement pour 0 et 1.

Un enjeu lié au calcul quantique est de pouvoir manipuler individuellement ces qubits de spin. Une façon de distinguer les qubits entre eux consiste à leur affecter des fréquences de résonance de spin différentes. La commande de l'état de spin de ces différents qubits peut alors se faire en appliquant des fréquences radio sensiblement différentes.

Le document US 2010270534 A1 divulgue différentes configurations de dispositifs à qubits de spin permettant de contrôler individuellement les qubits. En particulier, ces dispositifs comprennent un aimant ferromagnétique produisant un gradient de champ magnétique au niveau des qubits. L'intensité du champ magnétique résultant est ainsi modifiée localement en fonction des positions des qubits. Les niveaux d'énergie, et la fréquence de résonance correspondante sont donc différents d'un qubit à l'autre. La commande individuelle des qubits est ainsi rendue possible. Il est néanmoins nécessaire de prévoir une distance de séparation suffisamment grande entre les qubits pour pouvoir les distinguer. Cela limite la densité d'intégration des qubits de spin. Par ailleurs, l'utilisation d'un aimant permanent plutôt qu'un champ magnétique induit par une bobine ne permet pas de changer la configuration du dispositif à qubits de spin. Ces dispositifs ne sont donc pas reprogrammables pour effectuer d'autres opérations logiques par exemple.

Le document US2022083890 A1 enseigne de recourir à des nano-aimants identiques entre eux, de façon à pouvoir utiliser un même signal de contrôle pour contrôler individuellement chaque qubit de type point quantique disposé sous un aimant. Le document prévoit également la possibilité d'utiliser des nano-aimants d'intensités différentes ou placés à différentes altitudes vis-vis du point quantique sous-jacente.

Un objet de la présente invention est de pallier ces inconvénients.

En particulier, un objet de la présente invention est de proposer un dispositif à qubits de spin permettant la commande individuelle de qubits de façon améliorée. Un autre objet de la présente invention est de proposer un dispositif à qubits de spin permettant une densité d'intégration élevée. Un autre objet de la présente invention est de proposer un dispositif à qubits de spin pouvant être réinitialisé ou reconfiguré.

Un autre objet de la présente invention est de proposer un procédé de réalisation de ces dispositifs quantiques.

Les autres objets, caractéristiques et avantages de la présente invention apparaîtront à l'examen de la description suivante et des dessins d'accompagnement. Il est entendu que d'autres avantages peuvent être incorporés.

### RESUME

La présente invention est définie dans les revendications indépendantes. Les revendications dépendantes définissent des modes de réalisation particuliers.

Pour atteindre cet objectif, selon un mode de réalisation on prévoit un dispositif électronique comprenant au moins :
- un premier point quantique et un deuxième point quantique disposés le long **d'une direction** longitudinale, configurés pour présenter chacun deux états de spin opposés en présence d'un champ magnétique externe,
- une première grille de commande associée au premier point quantique,
- une deuxième grille de commande associée au deuxième point quantique,
- un aimant configuré pour générer localement un gradient de champ magnétique entre les premier et deuxième points quantiques, de sorte que les premier et deuxième points quantiques présentent respectivement des première et deuxième fréquences de résonnance différentes entre elles.

Avantageusement, l'aimant comprend au moins un premier domaine magnétique et un deuxième domaine magnétique répartis le long de la direction longitudinale et séparés par au moins une paroi de domaine.

Ces premier et deuxième domaines magnétiques présentent respectivement une première aimantation et une deuxième aimantation de sens opposés selon la direction longitudinale, de façon à générer localement ledit gradient de champ magnétique entre les premier et deuxième points quantiques. Les premier et deuxième points quantiques (également appelés Qdots de l'anglais « quantum dots ») perçoivent un champ magnétique résultant du champ magnétique externe et du champ magnétique de l'aimant, et présentent ainsi des première et deuxième fréquences de résonnance différentes entre elles, du fait du gradient de champ magnétique généré par l'aimant.

Le champ magnétique externe est sensiblement uniforme, en amplitude et en direction. Son intensité est typiquement de l'ordre du Tesla (T). Celui-ci correspond à la composante « macroscopique » du champ magnétique perçu par les points quantiques. Le champ magnétique généré par l'aimant présente des variations locales d'intensité et ou de directions , grâce aux différents domaines magnétiques de l'aimant. Celui-ci correspond à la composante « microscopique » du champ magnétique perçu par les points quantiques. Son intensité est typiquement de l'ordre de la dizaine ou de quelques dizaines de milliTesla (mT). Chaque point quantique perçoit donc la superposition des composantes macroscopique et microscopique du champ magnétique résultant. La modulation selon la direction longitudinale du champ magnétique produit par l'aimant, génère une composante microscopique qui prend alternativement des valeurs d'amplitude différentes pour chacun des premier et deuxième points quantiques. Il en résulte avantageusement que les premier et deuxième points quantiques présentent des première et deuxième fréquences de résonnance différentes entre elles.

Les aimantations opposées des deux domaines magnétiques permettent d'augmenter le gradient de champ magnétique entre les points quantiques. Ainsi, les fréquences de résonnance permettant aux premier et deuxième points quantiques de passer d'un état de spin à l'autre sont significativement différentes. Les premier et deuxième points quantiques peuvent donc être commandés individuellement. Cette augmentation de gradient de champ magnétique permet avantageusement d'augmenter la densité d'intégration des points quantiques, tout en conservant un bon contrôle de l'état de spin de chacun des points quantiques.

Selon une possibilité, la ou les parois séparant les domaines magnétiques de l'aimant peuvent être déplacées, notamment en appliquant un courant électrique au sein de l'aimant selon la direction longitudinale. Cela permet avantageusement de reconfigurer le dispositif et de modifier les paramètres de commande du dispositif à qubits de spin. Le dispositif est donc reprogrammable.

Selon un aspect, on prévoit un système comprenant au moins un dispositif électronique tel que décrit, le système étant pris parmi : un calculateur ou un accélérateur quantique, ou un routeur quantique.

Selon un aspect de l'invention, on prévoit un procédé de réalisation d'un tel dispositif électronique comprenant au moins les étapes suivantes :
- Former les premier et deuxième points quantiques,
- Former les première et deuxième grilles de commande associées auxdits premier et deuxième points quantiques,
- Former l'aimant en effectuant au moins les étapes suivantes :
   ∘ Déposer un matériau ferromagnétique,
   ∘ Déplacer la paroi de domaine au sein du matériau ferromagnétique de façon à former les premier et deuxième domaines magnétiques, en appliquant un courant électrique le long de la direction longitudinale.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La figure 1 illustre les fluctuations des composantes Bx et Bz du champ magnétique induit par les domaines magnétiques de l'aimant selon un mode de réalisation de la présente invention.
La figure 2A illustre schématiquement en coupe transverse un dispositif électronique selon un premier mode de réalisation de la présente invention.
La figure 2B illustre schématiquement en vue de dessus le dispositif électronique illustré à la figure 2A.
La figure 3A illustre schématiquement en coupe transverse un dispositif électronique, selon un deuxième mode de réalisation de la présente invention.
La figure 3B illustre schématiquement en vue de dessus le dispositif électronique illustré à la figure 3A.
La figure 4A illustre schématiquement en coupe transverse un dispositif électronique, selon un troisième mode de réalisation de la présente invention.
La figure 4B illustre schématiquement en vue de dessus le dispositif électronique illustré à la figure 4A.
La figure 5 illustre schématiquement en vue de dessus un dispositif électronique selon un quatrième mode de réalisation de la présente invention.
La figure 6 illustre schématiquement un dispositif électronique selon un mode de réalisation de la présente invention.
La figure 7 illustre schématiquement un dispositif électronique selon un autre mode de réalisation de la présente invention.
La figure 8 illustre schématiquement en vue de dessus un ruban comprenant des encoches destinées à fixer les parois de domaine, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les dimensions des différents éléments et couches ne sont pas nécessairement représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'aimant comprend une pluralité de premier et deuxième domaines magnétiques répartis le long de la direction longitudinale, alternés les uns les autres, et séparés par une pluralité de parois de domaine, le dispositif comprenant en outre une pluralité de points quantiques répartis le long de la direction longitudinale et une pluralité de grilles de commande associées auxdits points quantiques. Selon un exemple, le nombre de points quantiques est en relation avec le nombre de magnétiques. Ainsi, chaque point quantique peut être associé à un domaine magnétique distinct. Alternativement, plusieurs points quantiques peuvent être associés à un même domaine magnétique. Cela permet de concevoir différentes architectures pour la commande de points quantiques individuels ou de groupes de points quantiques. Selon une architecture particulière, le dispositif comprend N points quantiques et l'aimant comprend N domaines magnétiques séparés par N-1 parois. Chaque point quantique est en correspondance avec un domaine magnétique dans cette configuration. Selon une autre architecture particulière, le dispositif comprend N points quantiques et l'aimant comprend N parois séparant N+1 domaines magnétiques. Chaque point quantique est en correspondance avec une paroi dans cette configuration. Selon une autre architecture, le dispositif comprend N points quantiques et l'aimant comprend M domaines magnétiques séparés par M-1 parois. Un ou plusieurs points quantiques sont en correspondance avec un même domaine magnétique dans cette configuration. Dans cette configuration, par exemple, deux points quantiques adjacents peuvent être mis en regard de domaines magnétiques ou de parois de même direction d'aimantation.

Selon un exemple, deux points quantiques adjacents de la pluralité de points quantiques sont séparés par une distance L selon la direction longitudinale, de préférence L ≤ 200 nm. Selon un exemple, les domaines magnétiques présentent une dimension n.L selon la direction longitudinale, avec n un entier naturel non nul, typiquement compris entre 1 et N - M + 1. La dimension des domaines magnétiques correspond ici sensiblement à un multiple de la distance séparant deux points quantiques adjacents. Cela permet d'obtenir des fluctuations périodiques ou pseudo-périodiques de champ magnétique présentant une période proportionnelle ou identique à celle de l'arrangement des points quantiques le long de la direction longitudinale. Cela permet de disposer les points quantiques en correspondance avec les variations de champ magnétique les plus fortes. Selon une possibilité, les domaines magnétiques présentent des dimensions n.L variables le long de la direction longitudinale. La distribution de domaines magnétiques de différentes dimensions n'est donc pas périodique le long de la direction longitudinale, mais cette distribution reste corrélée à l'arrangement des points quantiques. Un domaine magnétique de dimension 3L peut ainsi être en correspondance avec 3 points quantiques. Ce domaine magnétique peut être suivi selon la direction longitudinale par un autre domaine magnétique de dimension L, en correspondance avec 1 point quantique. Ainsi, les domaines magnétiques de dimension nL sont de préférence en correspondance avec n points quantiques.

Selon un exemple, l'aimant se présente sous forme d'un ruban et la paroi de domaine est fixée transversalement au ruban par des encoches au niveau des bords du ruban. Le ruban présente de préférence une dimension selon la direction longitudinale supérieure, et de préférence très supérieure, aux dimensions transverses à la direction longitudinale. Ainsi, un ruban correspondant sensiblement à un pavé de dimensions Lx selon la direction longitudinale, Ly et Lz selon des directions d'un plan transverse à la direction longitudinale, est de préférence dimensionné tel que 1 ≤ Ly/Lx ≤ 3 et Lz ≈ 0,2.Lx. La paroi de domaine s'étend typiquement principalement le long d'un plan transverse à la direction longitudinale, en étant fixée ou bloquée dans le ruban par les encoches formées de part et d'autre du ruban. Les encoches forment typiquement un rétrécissement de la section transverse du ruban. Elles peuvent être rectangulaires, par exemple de dimensions nₓ comprise entre 15 et 30 nm, et n_{y} entre 10% à 20% de Lx. Les encoches permettent avantageusement de contrôler les positions des parois de domaine.

Selon un exemple, l'aimant se présente sous forme d'un ruban et l'au moins une paroi de domaine est fixée transversalement au ruban par une variation discontinue de section transverse du ruban. Un brusque rétrécissement ou élargissement de la largeur du ruban peut ainsi permettre la fixation d'une paroi de domaine.

Selon un exemple, le ruban est à base de Fe, Co, Ni, ou B ou d'alliages de ces métaux, par exemple CoFe ou Ni₈₀Fe₂₀ ou CoFeB. Le matériau ferromagnétique de l'aimant ou du ruban n'est cependant pas limité à ce choix de métaux ou d'alliages.

Selon un exemple, le dispositif comprend en outre un générateur de parois de domaine en bordure de l'aimant. Cela permet le cas échéant de générer ou régénérer des parois de domaine au sein de l'aimant. Un tel générateur de paroi peut se présenter sous la forme d'une structure d'injection à base de matériau ferromagnétique de larges dimensions accolée à l'une des extrémités de l'aimant ou du ruban. Une telle structure est par exemple décrite dans le document « R.P. Cowburn, Journal of Applied Physics 91, 6949 (2002) ».

Selon un exemple, le dispositif comprend N points quantiques occupant N positions P1 à P_{N} réparties le long de la direction longitudinale, N grilles associées auxdits N points quantiques, et l'aimant comprend N +1 domaines magnétiques présentant des aimantations opposées en alternance et séparés par N parois de domaine, lesdites N parois comprenant respectivement N plans transverses à la direction longitudinale passant par les positions P1 à P_{N} des N points quantiques. Dans ce mode de réalisation, les parois de domaine peuvent être sensiblement situées à l'aplomb des points quantiques. Les points quantiques ne sont pas disposés en regard des domaines magnétiques, ils sont situés en regard des parois séparant lesdits domaines magnétiques, c'est-à-dire à une abscisse Xn= nL avec n = 1... N, pour des points quantiques régulièrement séparés par une distance L selon la direction longitudinale. Dans ce mode de réalisation, les points quantiques sont soumis à un gradient maximum de la composante Bz du champ magnétique généré par l'aimant.

Selon un exemple, le dispositif comprend N points quantiques régulièrement séparés par une distance L selon la direction longitudinale, N grilles associées auxdits N points quantiques, et l'aimant comprend N domaines magnétiques de dimension sensiblement égale à L selon la direction longitudinale, présentant des aimantations opposées en alternance et séparés par N-1 parois de domaine, lesdits N points quantiques étant répartis le long de la direction longitudinale en regard et en correspondance des N domaines magnétiques, chaque point quantique occupant selon la direction longitudinale une position comprise entre L/2 et L vis-à-vis d'une extrémité du domaine magnétique correspondant, avantageusement une position située à 3/4L vis-à-vis d'une extrémité du domaine magnétique correspondant.

Selon un exemple, le dispositif comprend N points quantiques régulièrement séparés par une distance L selon la direction longitudinale, N grilles associées auxdits N points quantiques, et l'aimant comprend N domaines magnétiques de dimension sensiblement égale à L selon la direction longitudinale, présentant des aimantations opposées en alternance et séparés par N-1 parois de domaine, lesdits N points quantiques étant répartis le long de la direction longitudinale en regard et en correspondance des N domaines magnétiques, chaque point quantique occupant selon la direction longitudinale une position sensiblement située à 3/4L vis-à-vis d'une extrémité du domaine magnétique correspondant. Dans ce mode de réalisation, les points quantiques sont disposés en regard des domaines magnétiques, à 3/4L du bord de chaque domaine magnétique selon la direction longitudinale, c'est-à-dire à une abscisse Xn = 3/4L + (n-1)L, avec n=1... N . Dans ce mode de réalisation, les points quantiques sont soumis un gradient maximum de la somme des composantes Bx + Bz du champ magnétique généré par l'aimant.

Selon un exemple, le dispositif comprend N points quantiques régulièrement séparés par une distance L selon la direction longitudinale, N grilles associées auxdits N points quantiques, et dans lequel l'aimant comprend N domaines magnétiques de dimension sensiblement égale à L selon la direction longitudinale, présentant des aimantations opposées en alternance et séparés par N-1 parois de domaine, lesdits N points quantiques étant répartis le long de la direction longitudinale en regard et en correspondance des N domaines magnétiques, chaque point quantique occupant selon la direction longitudinale une position sensiblement située à L/2 vis-à-vis d'une extrémité du domaine magnétique correspondant. Dans ce mode de réalisation, les points quantiques sont disposés en regard des domaines magnétiques, à L/2 du bord de chaque domaine magnétique selon la direction longitudinale, c'est-à-dire à une abscisse Xn=L/2 + (n-1)L, avec n=1... N. Dans ce mode de réalisation, les points quantiques sont soumis un gradient maximum de la composante Bx du champ magnétique généré par l'aimant.

Selon un exemple, le dispositif comprend au moins une première ligne et une deuxième ligne parallèles entre elles et dirigées selon la direction longitudinale, chaque ligne comprenant au moins deux points quantiques et deux grilles de commandes associées chacune respectivement à un desdits points quantiques, le dispositif comprenant en outre au moins un premier aimant et un deuxième aimant associés respectivement aux première et deuxième lignes, chaque aimant comprenant au moins les premier et deuxième domaines magnétiques répartis le long de la direction longitudinale et séparés par une paroi de domaine, lesdits premier et deuxième domaines magnétiques présentant respectivement les première et deuxième aimantations de sens opposés selon la direction longitudinale, le premier aimant étant disposé parallèlement à la première ligne et le deuxième aimant étant disposé parallèlement à la deuxième ligne, de sorte à générer localement un premier gradient de champ magnétique entre les premier et deuxième points quantiques de la première ligne, et un deuxième gradient de champ magnétique entre les premier et deuxième points quantiques de la deuxième ligne. Dans ce mode de réalisation, les points quantiques sont distribués de façon matricielle, en lignes et colonnes. Des aimants, comprenant chacun une pluralité de domaines magnétiques répartis selon la direction longitudinale et présentant des aimantations opposées en alternance, sont associés à chacune des lignes de points quantiques. En présence du champ magnétique externe, chaque point quantique présente deux états de spin opposés, par effet Zeeman. Pour chaque ligne, l'aimant associé produit un champ magnétique variant localement au niveau des points quantiques de ladite ligne. Il est donc possible de configurer les aimants des différentes lignes de façon à ce que des points quantiques adjacents, pris dans les lignes et les colonnes, présentent des fréquences de résonnance différentes entre elles. L'état de spin de chaque point quantique peut ainsi être contrôlé individuellement par une grille de commande associée audit point quantique. Selon une possibilité, les grilles de commande sont disposées selon les colonnes de la matrice de points quantiques. Le dispositif permet ainsi de commander individuellement les points quantiques d'une matrice de points quantiques.

Selon un exemple, les première et deuxième aimantations des premier et deuxième domaines magnétiques du premier aimant présentent respectivement le même sens que les première et deuxième aimantations des premier et deuxième domaines magnétiques du deuxième aimant, aux mêmes positions selon la direction longitudinale le long des première et deuxième lignes. Les premier et deuxième aimants présentent ainsi côte-à-côte sensiblement la même distribution de champ magnétique. Cela permet d'éviter une potentielle compensation de champ issu du premier aimant par le deuxième aimant. Cela permet de maximiser les fluctuations de champ le long des première et deuxième lignes.

Selon un exemple, les première et deuxième aimantations des premier et deuxième domaines magnétiques du premier aimant présentent respectivement un sens opposé aux deuxième et première aimantations des deuxième et premier domaines magnétiques du deuxième aimant, aux mêmes positions selon la direction longitudinale le long des première et deuxième lignes. Les premier et deuxième aimants présentent ainsi côte-à-côte des champs magnétiques sensiblement en opposition de phase. Cela permet de bien différencier la fréquence de résonance d'un qubit donné vis-à-vis des fréquences de résonance des qubits plus proches voisins de ce qubit.

Selon un exemple, une même ligne peut comprendre un ou plusieurs rubans d'aimant parallèles entre eux et présentant les mêmes domaines d'aimantations. Cela permet de renforcer le champ magnétique local créé par l'aimant. Les points quantiques peuvent ainsi être plus éloignés de l'aimant. Cela permet d'augmenter le nombre de configurations possibles pour l'agencement et le placement des points quantiques vis-à-vis de l'aimant.

Selon un exemple, le procédé de réalisation du dispositif comprend en outre, avant le déplacement de la paroi de domaine, une génération d'au moins une paroi de domaine au sein du matériau ferromagnétique. Cette génération peut typiquement être effectuée par un générateur de parois de domaine situé à proximité de l'aimant. Cela permet de former au moins une paroi de domaine, dans le cas où l'aimant ne présenterait aucune paroi de domaine.

Selon un exemple, le procédé de réalisation du dispositif comprend en outre, après dépôt du matériau ferromagnétique sous forme d'un ruban, une formation par lithographie et gravure d'encoches sur des bords opposés du ruban, lesdites encoches étant destinées à fixer la paroi de domaine lors du déplacement de la paroi de domaine. La paroi se déplace typiquement selon la direction longitudinale. Elle s'étend transversalement. Les encoches formées de part et d'autre du ruban forment localement un rétrécissement de la section transverse de l'aimant. Cela permet de bloquer la progression longitudinale des parois. Les parois sont ainsi fixées ou ancrées au niveau des encoches. Selon un exemple, une simple variation discontinue de section transverse du ruban est formée par lithographie et gravure. Cela permet également la fixation d'une paroi de domaine transversalement au ruban, au niveau de cette variation discontinue.

La répartition des domaines magnétiques au sein de l'aimant peut être modifiée en déplaçant les parois de domaines. L'application d'un courant électrique dans l'aimant, dans un sens orienté selon la direction longitudinale, permet de déplacer longitudinalement les parois. L'aimant peut ainsi être réinitialisé ou reconfiguré. En fonction du courant électrique appliqué lors de l'initialisation ou de la reconfiguration de l'aimant, il est ainsi possible de modifier les paramètres de commande des qubits. Une programmation ou reprogrammation des lignes ou matrices de points quantiques est ainsi avantageusement rendue possible. Le déplacement de parois peut être réalisé par l'application d'un courant ou par la combinaison d'une application d'un courant et d'un champ magnétique. Cette dernière possibilité permet avantageusement de baisser le niveau de courant nécessaire aux déplacements de parois.

Selon un exemple, en choisissant de former des points d'ancrage (par encoche ou par variation de section) le long du ruban avec un pas de L/2, les parois peuvent être déplacées via des positions intermédiaires. Cela permet d'envisager de configurer deux points quantiques consécutifs sous un environnement magnétique similaire. Par ailleurs, en changeant le sens d'application du courant électrique dans l'aimant, il est également possible d'inverser le sens de déplacement des différentes parois. Le dispositif et son procédé de réinitialisation ou de reconfiguration permettent ainsi avantageusement d'obtenir un grand nombre de configurations d'aimants. Cela permet avantageusement une programmation versatile des lignes ou matrices de points quantiques.

Selon un exemple, le procédé de réinitialisation ou de reconfiguration du dispositif comprend en outre une génération d'au moins une nouvelle paroi de domaine, et une deuxième application d'un courant électrique dans l'aimant, le long de la direction longitudinale, de façon à déplacer l'au moins une nouvelle paroi de domaine dans une nouvelle position vis-à-vis des premiers et deuxièmes points quantiques.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques d'un aspect de l'invention, par exemple le dispositif ou le procédé, peuvent être adaptées *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche. La direction longitudinale est prise selon x.

Les termes relatifs « sur », « surmonte », « sous », « sous-jacent », « intercalé » se réfèrent à des positions prises selon la direction z.

Les termes « transverse », « transversalement » se réfèrent au plan zy ou à une direction de ce plan zy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux dans un même plan comprenant la direction z, de préférence dans un plan zy.

Une paroi de domaine ou paroi magnétique est une zone de transition entre deux domaines d'aimantation différentes (également appelés domaines de Weiss) dans un matériau ferromagnétique. Un domaine magnétique, ou domaine de Weiss, est une région d'un matériau dans laquelle les moments magnétiques sont orientés dans la même direction, l'aimantation y est donc uniforme. La région séparant les domaines magnétiques est appelée paroi de domaine, dans laquelle l'aimantation change progressivement ou brusquement de direction. Dans un domaine magnétique, les moments magnétiques de chaque atome sont très majoritairement alignés les uns avec les autres et pointent dans la même direction. La structure des domaines magnétiques est responsable du comportement magnétique des matériaux ferromagnétiques comme le fer, le nickel, le cobalt et de leurs alliages.

On utilise le terme paroi pour décrire l'interface entre deux domaines magnétiques (ou domaines de Weiss). La paroi de domaine marque le passage d'une zone aimantée à une autre. Pour autant, ce n'est pas nécessairement une variation brusque : le changement peut se faire graduellement, sur une distance finie, avec un renversement progressif, continu ou désorganisé de l'orientation du moment magnétique. La paroi de domaine peut donc présenter une certaine largeur selon la direction longitudinale x.

Selon un exemple, une paroi de domaine dite de Bloch est une zone de transition entre deux domaines de Weiss dans un matériau. C'est une région où les moments magnétiques changent graduellement d'un domaine de Weiss à l'autre, dans le plan de la paroi, typiquement dans le plan yz.

De façon analogue aux parois de Bloch, les parois de Néel, qui sont un autre type de parois de domaine, correspondent aussi à un changement de direction de l'aimantation entre deux domaines de Weiss. Ici, la direction du moment magnétique varie dans le plan de l'aimantation (plan de la couche mince magnétique, typiquement xy sur les figures). Les parois de Néel se forment préférentiellement dans le cas des couches minces magnétiques qui ont une épaisseur inférieure à une valeur critique, généralement de l'ordre de la dizaine de nanomètres.

Dans le cadre de la présente invention, une paroi de domaine s'étend principalement le long d'un plan transverse yz et présente généralement une certaine épaisseur selon la direction longitudinale x. Fonctionnellement, une paroi de domaine sépare deux domaines magnétiques d'aimantations différentes, en particulier d'aimantations opposées. Une paroi de domaine est souvent rattachée à une anomalie physique, par exemple un bord, une encoche, un défaut. Elle peut néanmoins être libre et bouger rapidement au sein d'une couche ou d'un ruban de matériau magnétique. Une paroi de domaine est une zone de taille finie qui comprend généralement une pluralité d'orientations de moments magnétiques distribuées de façon globalement continue mais souvent chaotique.

On entend par gradient de champ magnétique une variation de l'intensité du champ magnétique, en Tesla, notamment selon la direction longitudinale x. Le sens et la valeur de l'aimantation d'un domaine magnétique peuvent être mesurés par des mesures d'œrsted (Oe) ou de Gauss. Des mesures d'aimantation locales par microscopie par force magnétique avec une pointe elle-même aimantée peuvent également permettre de cartographier les domaines magnétiques d'un aimant.

La direction longitudinale x est portée par un axe rectiligne sur les figures d'accompagnement. Il est parfaitement envisageable de mettre en œuvre l'invention pour des géométries curvilignes. Un ruban en forme de S ou de C peut également comprendre des domaines magnétiques séparés par des parois de domaines, fixes et/ou mobiles le long de la direction longitudinale x curviligne. Différentes géométries de ruban peuvent donc être envisagées sans se départir du principe de la présente invention.

De manière générale, la fréquence de résonnance d'un qubit dépend de l'amplitude du champ magnétique auquel il est soumis. Dans la présente invention les différentes amplitudes de champ auquel sont soumis les qubits sont les résultantes entre le champ externe homogène et fixe et le champ magnétique oscillant et programmable de l'aimant (ou ruban) dont les oscillations dépendent des positions des parois.

De plus afin d'être manipulé un qubit doit être soumis à un gradient de champ. Dans la présente invention, la position relative entre les qubits et les domaines et/ou parois de domaine permet à la fois d'obtenir la bonne amplitude de champ pour atteindre les différentes fréquences de résonance, et le gradient de champ pour la manipulation des qubits.

La possibilité de déplacer les parois permet avantageusement de rendre les champs du ou des rubans programmables, afin de configurer la ligne ou la matrice de qubits selon les besoins.

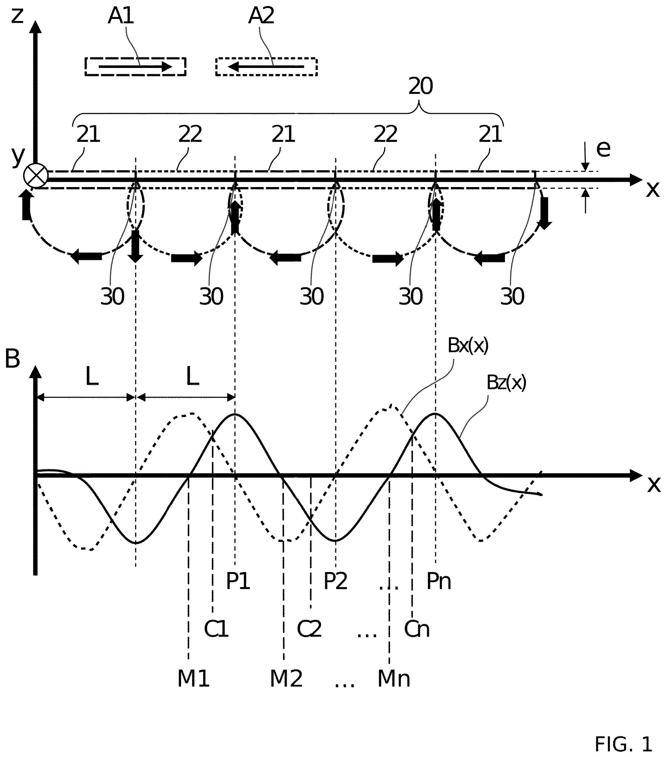

Comme illustré schématiquement à la figure 1, plusieurs domaines magnétiques 21, 22 sont répartis au sein de l'aimant 20 en alternance selon la direction x. Ces domaines magnétiques 21, 22 sont séparés les uns des autres par des parois de domaine 30 telles que décrites ci-dessus, par exemple des parois de Bloch ou des parois de Néel. Ils présentent typiquement chacun une longueur L selon x, comprise entre 20 nm et 200 nm, de préférence entre 40 nm et 100 nm, par exemple de l'ordre de 50 nm. L'épaisseur e selon z de l'aimant 20 et des domaines magnétiques 21, 22, est typiquement comprise entre 5 nm et 20 nm, de préférence de l'ordre de 10 nm. La largeur selon y de l'aimant 20 et des domaines magnétiques 21, 22, est typiquement comprise entre 20 nm et 200 nm, de préférence entre 50 nm et 150 nm.

Les domaines magnétiques 21, 22 présentent chacun une aimantation A1, A2 dirigée selon x. L'aimantation A1 des domaines magnétiques 21 présente un premier sens, par exemple pointé vers le côté droit de la feuille sur la figure 1, tandis que l'aimantation A2 des domaines magnétiques 22 présente un deuxième sens, par exemple pointé vers le côté gauche de la feuille sur la figure 1. Chaque domaine magnétique 21, 22 est défini par une seule aimantation A1, A2 présentant un seul sens. L'aimant 20 présente ainsi une succession de domaines magnétiques 21, 22 dont les aimantations A1, A2 sont alternées en opposition les unes des autres selon x. Cela produit un champ magnétique principalement orienté suivant x. Au niveau des parois 30, des composantes de champ apparaissent suivant y et z tandis que la composante de champ suivant x s'annule pour changer de sens. Les composantes du champ magnétique de l'aimant 20 présentent ainsi une oscillation selon la direction longitudinale x. Dans cet exemple, l'oscillation des composantes du champ est périodique.

Les courbes Bz(x) et Bx(x) correspondent aux composantes Bz et Bx du champ magnétique induit par l'aimant 20, selon la direction longitudinale x. Ces courbes Bz(x) et Bx(x) présentent typiquement une période équivalente à la longueur de deux domaines magnétiques adjacents 21, 22, et sont décalées entre elles d'un quart de période selon x. Différentes positions le long de x correspondent à des maxima de l'oscillation du champ magnétique. Les positions Pi (i=1... n) situées typiquement à l'aplomb des parois de domaine 30 sont ainsi soumises à une variation maximale de la composante Bz du champ magnétique. Les positions Mi (i=1... n) situées typiquement au milieu des domaines magnétiques 21, 22, en projection selon z, sont ainsi soumises à une variation maximale de la composante Bx du champ magnétique. Les positions Ci (i=1...n) situées typiquement aux 3/4 de la longueur L de chaque domaine magnétique 21, 22, c'est-à-dire à mi-distance entre les positions Pi et Mi, sont ainsi soumises à une variation maximale de la somme des composantes Bx + Bz du champ magnétique.

Pour maximiser la différenciation entre fréquences de résonance des points quantiques, il est donc particulièrement avantageux de disposer les points quantiques en regard de ces positions Pi et/ou Mi et/ou Ci. En particulier, les positions des points quantiques QDi (i=1...n) pour un dispositif électronique à qubits de spin peuvent être avantageusement choisies de façon à ce qu'elles partagent chacune un même plan yz avec les positions Pi et/ou Mi et/ou Ci. Il apparaît également qu'une pluralité de positions Pi et/ou Mi et/ou Ci peuvent convenir pour la disposition des points quantiques le long de x. Cela permet d'obtenir une tolérance de placement des points quantiques le long de la direction longitudinale x, relativement à la position des domaines magnétiques 21, 22 et/ou des parois 30. L'alternance des aimantations au sein de l'aimant 20, et les oscillations induites dans le champ magnétique résultant, permettent ainsi de maximiser le nombre de positions pour lesquelles la variation de champ magnétique est importante. Cela permet notamment de densifier le nombre de points quantiques le long de x.

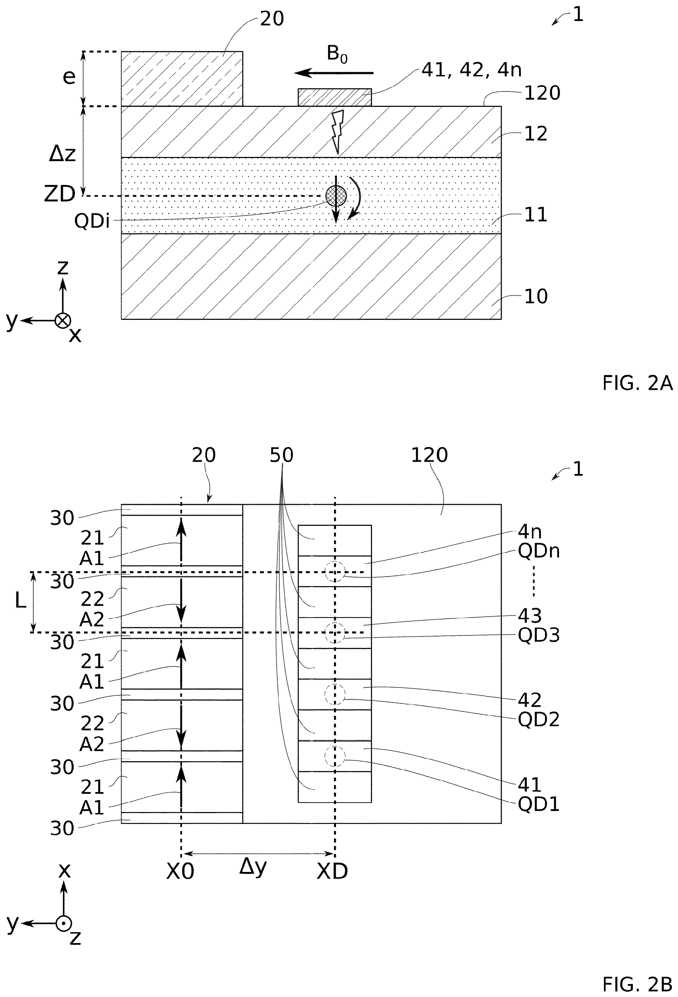

Les figures 2A, 2B, 3A, 3B, 4A, 4B et 5 illustrent différents modes de réalisation d'un dispositif électronique à qubits de spin comprenant un tel aimant 20 présentant des domaines magnétiques 21, 22 d'aimantations alternées. A titre d'exemple, les domaines magnétiques 21, 22 présentent tous ici une longueur L selon x de l'ordre de 50 nm, et une aimantation à 1,5 T/m³. Pour ces modes de réalisation, les points quantiques QDi sont positionnés en regard des parois de domaine 30, c'est-à-dire aux positions Pi selon x. Chaque point quantique QDi et sa paroi de domaine 30 correspondante forment ainsi une intersection avec un même plan yz. Par souci de concision, les autres configurations, notamment la disposition des points quantiques QDi en regard des positions Mi ou Ci, ne sont pas illustrées. Ces configurations peuvent être néanmoins facilement déclinées à partir des exemples illustratifs suivants, et sont parfaitement envisageables.

Les figures 2A et 2B illustrent respectivement en coupe transverse et en vue de dessus un premier mode de réalisation du dispositif 1 dans lequel l'aimant 20 sous forme de ruban est décalé verticalement et latéralement vis-à-vis des points quantiques QDi (i=1... n).

Les points quantiques QDi peuvent être formés de façon classique dans une couche 11 à base de silicium intercalée entre deux couches 10, 12 à base d'oxyde de silicium. Des grilles de commande 4i (i=1... n), configurées pour générer des ondes radiofréquences (RF) permettant une transition de l'état de spin des points quantiques, sont de préférence situées verticalement à l'aplomb des points quantiques QDi, sur la face supérieure 120 de la couche 12. Pour chaque point quantique, la fréquence f de l'onde RF qui permet la transition de l'état de basse énergie vers celui de plus haute énergie du spin d'un électron est f = (g.µ_{B}.B_{T})/h, où g est le facteur de Landé (g = 2 dans le cas de l'électron), µ_{B} est le magnéton de Bohr (µ_{B} = 9,27.10⁻²⁴ J/T), h est la constante de Planck et B_{T} la valeur du champ magnétique perçu par le point quantique considéré. Cette fréquence f de résonance varie donc en fonction du champ magnétique perçu par le point quantique considéré. Selon une possibilité préférée, chaque point quantique QDi est associé à une grille de commande 4i distincte. Typiquement, pour des points quantiques voisins, une variation de fréquence de l'ordre de 10MHz permet de les commander indépendamment. Cette variation de fréquence correspond à une variation de champ magnétique total de 26,75 mT. Selon un principe de l'invention, la variation de champ magnétique total entre deux points quantiques voisins est maximisée en générant un champ magnétique oscillant via les domaines magnétiques 21, 22 d'aimantations A1, A2 opposées au sein du ruban 20.

Dans ce premier mode de réalisation, le ruban 20 est directement au contact de la face supérieure 120 de la couche 12. Il est situé à côté de la ligne de commande formée par les grilles 4i.

Comme illustré à la figure 2A en projection dans le plan yz, le décalage vertical Δz selon z, entre la face inférieure du ruban 20 et un axe ZD passant par les points quantiques QDi, est de préférence inférieur à 20 nm, typiquement pour une largeur du ruban de 150 nm.

Comme illustré à la figure 2B en projection dans le plan xy, le décalage latéral Δy selon y, entre un axe longitudinal central X0 du ruban 20 et un axe XD parallèle à X0 et passant par les points quantiques QDi, est de préférence inférieur à 100 nm, typiquement pour une largeur du ruban de 150 nm.

Comme le champ magnétique généré par les domaines magnétiques 21, 22 est relativement faible, typiquement de l'ordre de 8,95.10⁻²⁴ T, on placera avantageusement le ruban 20 au plus près des points quantiques QDi.

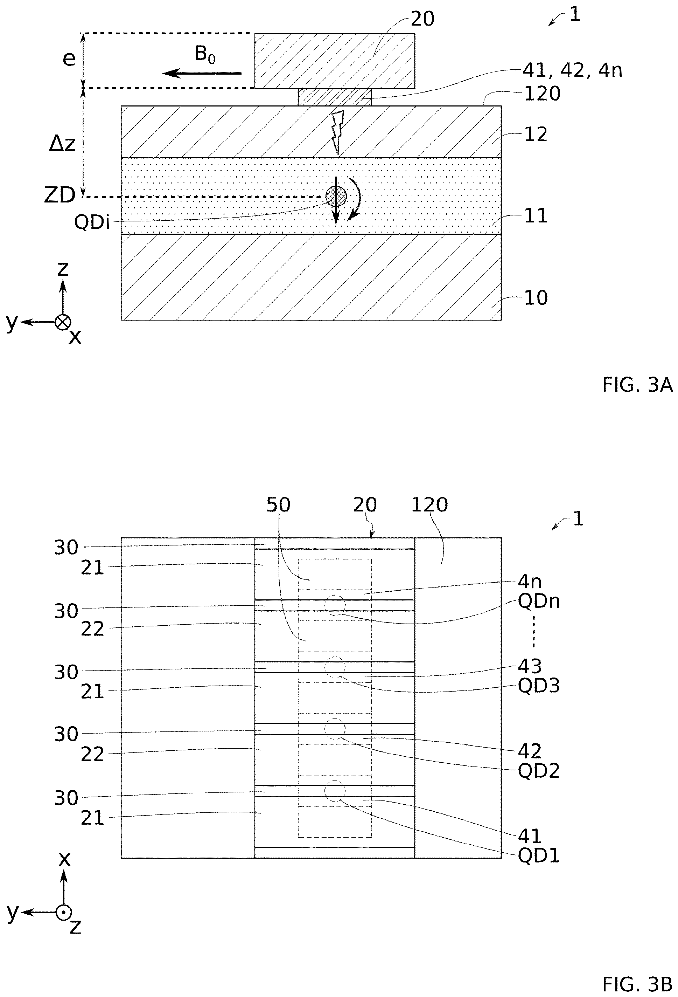

Les figures 3A et 3B illustrent respectivement en coupe transverse et en vue de dessus un deuxième mode de réalisation du dispositif 1 dans lequel le ruban 20 est à l'aplomb des points quantiques QDi (i=1... n), uniquement décalé verticalement vis-à-vis des points quantiques QDi.

Dans ce deuxième mode de réalisation, le ruban 20 est disposé sur la ligne de commande comprenant les grilles 4i. La ligne de commande est ainsi intercalée entre la face supérieure 120 de la couche 12 et la face inférieure du ruban 20.

Comme illustré à la figure 3A en projection dans le plan yz, le décalage vertical Δz selon z, entre la face inférieure du ruban 20 et l'axe ZD passant par les points quantiques QDi, est de préférence inférieur à 50 nm, typiquement pour une largeur du ruban de 50 nm.

Comme illustré à la figure 3B en projection dans le plan xy, l'axe longitudinal central X0 du ruban 20 et l'axe XD passant par les points quantiques QDi sont sensiblement superposés.

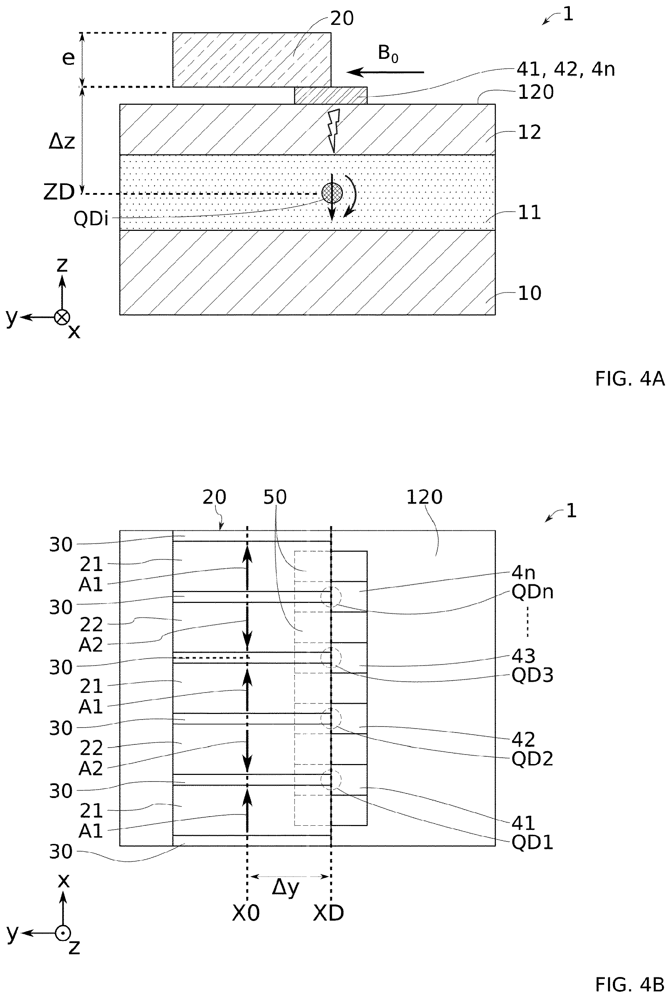

Les figures 4A et 4B illustrent respectivement en coupe transverse et en vue de dessus un troisième mode de réalisation du dispositif 1 dans lequel le ruban 20 chevauche en partie la ligne de commande comprenant les grilles 4i. Ce mode de réalisation est intermédiaire entre les deux modes de réalisation décrits précédemment.

Comme illustré à la figure 4A en projection dans le plan yz, le ruban 20 recouvre partiellement la ligne de commande. Le décalage vertical Δz selon z, entre la face inférieure du ruban 20 et l'axe ZD passant par les points quantiques QDi, est de préférence inférieur à 60 nm, typiquement pour une largeur du ruban de 100 nm.

Comme illustré à la figure 4B en projection dans le plan xy, le décalage latéral Δy selon y, entre l'axe longitudinal central X0 du ruban 20 et l'axe XD passant par les points quantiques QDi, est de préférence inférieur à 10 nm.

Les décalages vertical Δz et/ou latéral Δy peuvent être augmentés en augmentant typiquement la largeur du ruban. En particulier, un aimant de plus grandes dimensions développe un champ magnétique plus étendu, ce qui permet d'éloigner les axes ZD et/ou XD passant par les points quantiques QDi.

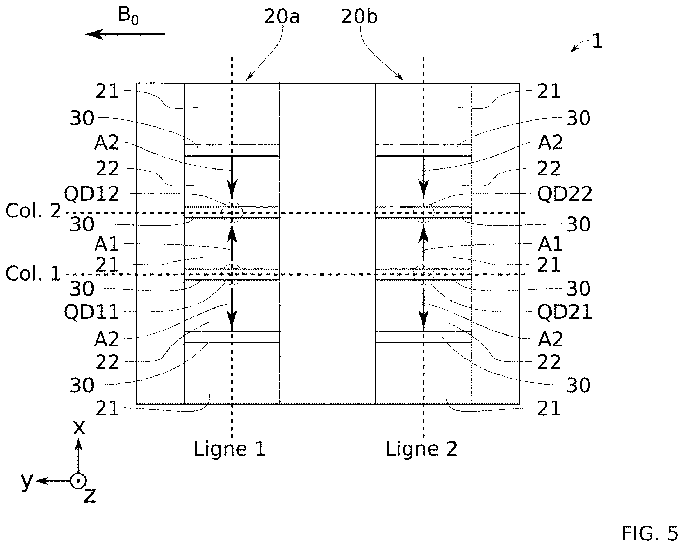

La figure 5 illustre en vue de dessus un autre mode de réalisation du dispositif 1 dans lequel deux rubans 20a, 20b sont disposés côte à côte le long d'une première ligne L1 et d'une deuxième ligne L2 parallèles entre elles et dirigées selon la direction longitudinale x. Des points quantiques QD11, QD12 sont situés sous le ruban 20a, à l'aplomb des parois de domaines 30. Des points quantiques QD21, QD22 sont situés sous le ruban 20b, à l'aplomb des parois de domaines 30. Des grilles de commande (non visibles) sont intercalées entre chaque point quantique et le ruban au-dessus. Les points quantiques QD11, QD12, QD21, QD22 forment ainsi une matrice de points quantiques organisée en lignes L1, L2 et colonnes C1, C2. Le point quantique QD11 appartient à la première ligne L1 et à la première colonne C1 ; le point quantique QD12 appartient à la première ligne L1 et à la deuxième colonne C2 ; le point quantique QD21 appartient à la deuxième ligne L2 et à la première colonne C1 ; le point quantique QD22 appartient à la deuxième ligne L2 et à la deuxième colonne C2. Les fréquences de résonance des colonnes C1 et C2 sont différentes. Chaque grille de commande peut être commandée indépendamment. Une telle disposition matricielle permet de densifier le nombre de points quantiques pouvant être commandés individuellement, par exemple en vue d'une application de calcul quantique.

Dans toutes les configurations décrites ci-dessus, le champ magnétique externe B₀ est de préférence appliqué perpendiculairement au ruban. Cela permet d'éviter toute interaction avec les domaines magnétiques du ruban. Le champ magnétique externe B₀ est typiquement statique et constant. Son intensité est typiquement de l'ordre du Tesla (T), par exemple comprise entre 0,5 T et 1,5 T. Il permet principalement de lever la dégénérescence de spin par effet Zeeman. Selon le principe de l'invention, ce champ magnétique externe B₀ est modulé localement par le champ magnétique du ruban, de sorte à générer des fréquences de résonance variables pour les différents points quantiques. Le champ magnétique externe B₀ peut provenir d'un générateur externe au dispositif, et indépendant de celui-ci. Selon une possibilité alternative, les grilles de commande RF peuvent produire ce champ magnétique externe B₀. Cela permet d'intégrer toutes les composantes de commande du dispositif au sein dudit dispositif.

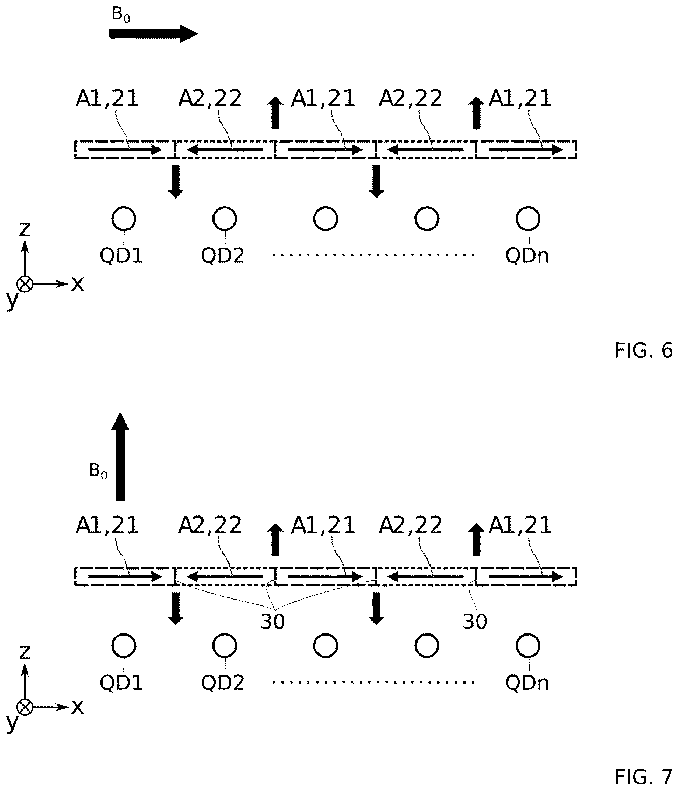

La figure 6 illustre un mode de réalisation où le champ magnétique externe B₀ est orienté selon la direction longitudinale x, c'est-à-dire selon la même direction que les moments magnétiques des aimantations A1, A2 des domaines magnétiques 21, 22. Les points quantiques QDi sont disposés en regard des domaines magnétiques, selon z. Dans ce cas, les points quantiques perçoivent une résultante du champ magnétique présentant des variations d'amplitude maximales, par addition des champs macroscopique (B₀) et local (généré par l'aimant) au niveau des domaines 21, 22.

La figure 7 illustre un autre mode de réalisation où le champ magnétique externe B₀ est orienté selon z, c'est-à-dire perpendiculairement à la direction des moments magnétiques des aimantations A1, A2 des domaines magnétiques 21, 22. Les points quantiques QDi sont ici disposés en regard des parois de domaines 30, selon z. Dans ce cas, les points quantiques perçoivent une résultante du champ magnétique présentant des variations d'amplitude maximales, par addition des champs macroscopique (B₀) et local (généré par l'aimant) au niveau des parois 30.

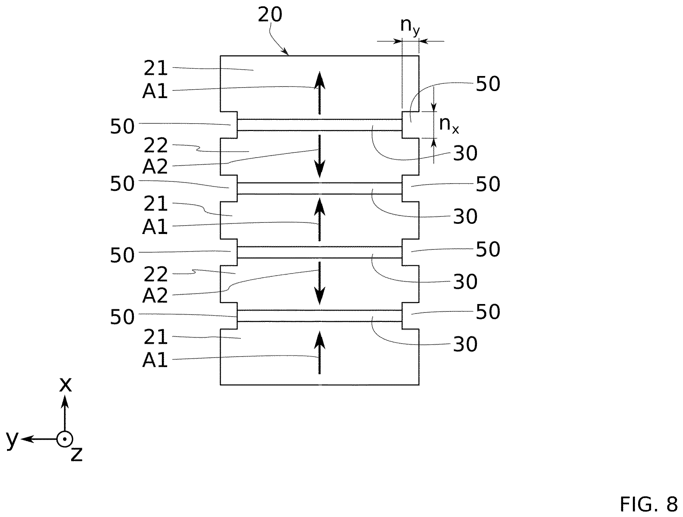

La figure 8 illustre un mode de réalisation avantageux du ruban 20 dans lequel les positions des parois de domaine 30 sont imposées par des encoches 50 pratiquées dans le ruban 20. Les encoches 50 forment typiquement un rétrécissement de la section transverse du ruban 20. Elles peuvent être rectangulaires, par exemple de dimensions nₓ selon x comprise entre 15 et 30 nm, et n_{y} selon y comprise entre 5 et 20 nm. Une paire d'encoches 50 de part et d'autre du ruban 20 permet typiquement de bloquer la progression d'une paroi 30 selon x, comme expliqué dans le document « Physical Review B, 79, 094430 (2009) ». Les positions des parois de domaine 30 peuvent ainsi être précisément contrôlées grâce à la présence d'encoches 50 réparties le long des bords longitudinaux du ruban 20.

La présente invention concerne également un procédé de réalisation d'un dispositif 1 tel que décrit précédemment.

Les points quantiques sont d'abord formés de façon connue dans une couche 11 semi-conductrice, par exemple à base de silicium ou de matériau III-V, le long d'un axe longitudinal XD avec de préférence une distance de séparation L entre chaque point quantique. Une couche diélectrique 12, par exemple à base de SiO2, peut ensuite être formée ou déposée sur la couche 11. Des grilles de commande sont ensuite formées classiquement, typiquement par lithographie, à l'aplomb des points quantiques. A ce stade, les qubits sont formés à partir d'une architecture de transistor à effet de champ métal-oxyde-semiconducteur MOSFET (acronyme de « Metal Oxide Semiconductor Field Effect Transistor »). D'autres architectures, par exemple basées sur un gaz bidimensionnel d'électrons, sont également possibles.

L'aimant peut ensuite être formé lors des étapes dites de fin de ligne BEOL (acronyme de « Back End Of Line ») des technologies de la microélectronique, par dépôt d'un ou plusieurs matériaux ferromagnétiques. De tels matériaux couramment utilisés dans l'industrie de la microélectronique sont typiquement à base de Fe, Co, B ou Ni, ou d'alliages de ces métaux (par exemple CoFe, CoFeB). Ils présentent de préférence une température de Curie supérieure à 1000°C. Ces matériaux ferromagnétiques peuvent être déposés par dépôt physique en phase vapeur PVD (acronyme de « Physical Vapor Deposition »), par exemple par pulvérisation cathodique à partir de cibles de l'alliage souhaité ou par co-pulvérisation à partir de cibles des métaux qui constituent l'alliage. Ils peuvent être mis en forme par lithographie, par exemple par lithographie électronique (à faisceau d'électrons), suivie d'une étape connue dite de « lift-off », ou d'une gravure de type gravure ionique par faisceau d'ions IBE (acronyme de « Ion Beam Etching »). Cela permet de structurer les matériaux ferromagnétiques typiquement sous forme d'un ruban comprenant des encoches espacées selon x d'une distance L ou nL, n étant un entier naturel non nul. Dans le mode de réalisation illustré à la figure 8, les encoches 50 sont typiquement « rentrantes ». Elles peuvent alternativement être de forme « sortante ». Selon une autre possibilité, la structuration du ruban par lithographie peut être configurée de façon à obtenir une succession de domaines magnétiques de largeurs selon y différentes, avec des variations brusques de section transverse entre deux domaines magnétiques adjacents. La largeur de ce ruban est de préférence de l'ordre de 50 à 150 nm. L'épaisseur de ce ruban est de préférence d'environ 10 nm. Différents exemples de ruban ferromagnétiques à base de CoFe ou de Ni₈₀Fe₂₀ sont par exemple respectivement décrits dans les documents « Tsoi et al, Appl. Phys. Lett., Vol. 8, No. 13, 2003 » et « Malinowski et al, J. Phys. D: Appl. Phys.,44, 384005, 2011 ».

Après structuration du ruban, un courant électrique est appliqué longitudinalement entre les deux extrémités du ruban. Ce courant électrique de l'ordre de 10⁶ à 10⁷ A/cm² permet d'orienter les domaines magnétiques et de déplacer les parois de domaine jusqu'aux points d'ancrage formés par les encoches.

Selon une possibilité non illustrée, un générateur de parois de domaine est formé à proximité ou à une extrémité du ruban. Un tel générateur de paroi peut se présenter sous la forme d'une structure d'injection à base de matériau ferromagnétique de larges dimensions accolée à l'une des extrémités de l'aimant ou du ruban. Une telle structure est par exemple décrite dans le document « R.P. Cowburn, Journal of Applied Physics 91, 6949 (2002) ». Cela permet d'initier et/ou de faciliter la création des parois de domaines.

Selon une possibilité avantageuse, le ruban peut être reconfiguré en appliquant un courant électrique longitudinalement. Certaines parois de domaine peuvent par exemple être déplacées et/ou empilées. Cela permet d'étendre certains domaines magnétiques et de réduire le nombre de parois de domaine. De nouvelles parois de domaine peuvent être créées par le générateur de parois de domaine, puis déplacées de nouveau. L'application d'un courant dans le ruban selon un premier sens déplace les parois dans ce même premier sens. Toutes les parois sont de préférence déplacées lors de l'application de ce courant. L'application d'un courant électrique selon un sens opposé au premier sens permet typiquement de changer le sens de déplacement des parois. Il est ainsi possible de réaffecter un domaine magnétique d'aimantation A2 à un point quantique donné, qui était auparavant associé à un domaine magnétique d'aimantation A1. Les fréquences de résonance des différents points quantiques peuvent ainsi être modifiées.

Le dispositif selon l'invention peut ainsi être reconfiguré de différentes manières, par exemple en fonction des applications visées.

L'invention n'est pas limitée aux modes de réalisation précédemment décrits. En particulier le nombre de domaines magnétiques, de points quantiques et de parois de domaine peut varier en fonction des applications. L'aimant peut également être associé à différentes architectures permettant de former des qubits. L'invention peut également être mise en œuvre pour des qubits de spin dont les porteurs de charge sont des trous.

## Revendications

1. Dispositif (1) électronique comprenant au moins :
- un premier point quantique (QD1) et un deuxième point quantique (QD2) disposés le long d'une direction longitudinale (x), configurés pour présenter chacun deux états de spin opposés en présence d'un champ magnétique externe (B0),
- une première grille (4₁) de commande associée au premier point quantique (QD1),
- une deuxième grille (4₂) de commande associée au deuxième point quantique (QD2),
- un aimant (20) configuré pour générer localement un gradient de champ magnétique entre les premier et deuxième points quantiques (QD1, QD2), de sorte que les premier et deuxième points quantiques (QD1, QD2) présentent respectivement des première et deuxième fréquences de résonnance différentes entre elles,
le dispositif (1) étant **caractérisé en ce que** l'aimant (20) comprend au moins un premier domaine magnétique (21) et un deuxième domaine magnétique (22) répartis le long de la direction longitudinale (x) et séparés par au moins une paroi de domaine (30), lesdits premier et deuxième domaines magnétiques (21, 22) présentant respectivement une première aimantation (A1) et une deuxième aimantation (A2) de sens opposés selon la direction longitudinale (x), de façon à générer localement ledit gradient de champ magnétique entre les premier et deuxième points quantiques (QD1, QD2).

2. Dispositif (1) selon la revendication précédente comprenant N points quantiques (QDi, i = 1... N) répartis le long de la direction longitudinale (x) et une pluralité de grilles (4i) de commande associées auxdits points quantiques (QDi), dans lequel l'aimant (20) comprend un nombre M de premier et deuxième domaines magnétiques (21, 22) répartis le long de la direction longitudinale (x), alternés les uns les autres, et séparés par M - 1 parois de domaine (30), dans lequel deux points quantiques adjacents (QD1, QD2) sont séparés par une distance L selon la direction longitudinale (x), et dans lequel un domaine magnétique pris parmi les premier et deuxième domaines magnétiques (21, 22) présente une dimension n.L selon la direction longitudinale (x), avec n un entier naturel non nul tel que 1 ≤ n ≤ N - M + 1.

3. Dispositif (1) selon l'une quelconque des revendications précédentes dans lequel l'aimant (20) se présente sous forme d'un ruban et dans lequel l'au moins une paroi de domaine (30) est fixée transversalement au ruban (20) par une variation discontinue de section transverse du ruban (20), par exemple par des encoches (50)au niveau des bords du ruban (20).

4. Dispositif (1) selon l'une quelconque des revendications précédentes comprenant en outre un générateur de parois de domaine en bordure de l'aimant (20).

5. Dispositif (1) selon l'une quelconque des revendications précédentes comprenant N points quantiques (QDi) occupant N positions P1 à PN réparties le long de la direction longitudinale (x), N grilles (4i) associées auxdits N points quantiques (QDi), et dans lequel l'aimant (20) comprend M domaines magnétiques (21, 22), M ≤ N+1, présentant des aimantations (A1, A2) opposées en alternance et séparés par M-1 parois (30) de domaine, lesdites M-1 parois (30) comprenant respectivement M-1 plans transverses à la direction longitudinale (x) passant chacun par une position prise parmi les positions P1 à PN des N points quantiques (QDi).

6. Dispositif (1) selon l'une quelconque des revendications 1 à 5 comprenant N points quantiques (QDi) régulièrement séparés par une distance L selon la direction longitudinale (x), N grilles (4i) associées auxdits N points quantiques (QDi), et dans lequel l'aimant (20) comprend N domaines magnétiques (21, 22) de dimension sensiblement égale à L selon la direction longitudinale (x), présentant des aimantations (A1, A2) opposées en alternance et séparés par N-1 parois (30) de domaine, lesdits N points quantiques (QDi) étant répartis le long de la direction longitudinale (x) en regard et en correspondance des N domaines magnétiques (21, 22), chaque point quantique occupant selon la direction longitudinale (x) une position située à 3/4L vis-à-vis d'une extrémité du domaine magnétique correspondant.

7. Dispositif (1) selon l'une quelconque des revendications 1 à 5 comprenant N points quantiques (QDi) régulièrement séparés par une distance L selon la direction longitudinale (x), N grilles (4i) associées auxdits N points quantiques (QDi), et dans lequel l'aimant (20) comprend N domaines magnétiques (21, 22) de dimension sensiblement égale à L selon la direction longitudinale (x), présentant des aimantations (A1, A2) opposées en alternance et séparés par N-1 parois (30) de domaine, lesdits N points quantiques (QDi) étant répartis le long de la direction longitudinale (x) en regard et en correspondance des N domaines magnétiques (21, 22), chaque point quantique occupant selon la direction longitudinale une position située à L/2 vis-à-vis d'une extrémité du domaine magnétique correspondant.

8. Dispositif selon l'une quelconque des revendications précédentes comprenant au moins une première ligne (L1) et une deuxième ligne (L2) parallèles entre elles et dirigées selon la direction longitudinale (x), chaque ligne (L1, L2) comprenant au moins deux points quantiques (QD11, QD12, QD21, QD22) et deux grilles de commandes associées chacune respectivement à un desdits points quantiques, le dispositif (1) comprenant en outre au moins un premier aimant (20a) et un deuxième aimant (20b) associés respectivement aux première et deuxième lignes (L1, L2), chaque aimant (20a, 20b) comprenant au moins les premier et deuxième domaines magnétiques (21, 22) répartis le long de la direction longitudinale (x) et séparés par une paroi de domaine (30), lesdits premier et deuxième domaines magnétiques (21, 22) présentant respectivement les première et deuxième aimantations (A1, A2) de sens opposés selon la direction longitudinale (x), le premier aimant (20a) étant disposé parallèlement à la première ligne (L1) et le deuxième aimant (20b) étant disposé parallèlement à la deuxième ligne (L2), de sorte à générer localement un premier gradient de champ magnétique entre les premier et deuxième points quantiques (QD11, QD12) de la première ligne (L1), et un deuxième gradient de champ magnétique entre les premier et deuxième points quantiques (QD21, QD22) de la deuxième ligne (L2).

9. Dispositif (1) selon la revendication précédente dans lequel les première et deuxième aimantations (A1, A2) des premier et deuxième domaines magnétiques (21, 22) du premier aimant (20a) présentent respectivement le même sens que les première et deuxième aimantations (A1, A2) des premier et deuxième domaines magnétiques (21, 22) du deuxième aimant (20b), aux mêmes positions selon la direction longitudinale (x) le long des première et deuxième lignes (L1, L2).

10. Système comprenant au moins un dispositif (1) selon l'une quelconque des revendications précédentes, le système étant pris parmi : un calculateur ou un accélérateur quantique, un routeur quantique.

11. Procédé de réalisation d'un dispositif (1) selon l'une quelconque des revendications 1 à 9 comprenant au moins les étapes suivantes :
- Former les premier et deuxième points quantiques (QD1, QD2),
- Former les première et deuxième grilles (41, 42) de commande associées auxdits premier et deuxième points quantiques (QD1, QD2),
- Former l'aimant (20) en effectuant au moins les étapes suivantes :
∘ Déposer un matériau ferromagnétique,
∘ Déplacer la paroi de domaine (30) au sein du matériau ferromagnétique de façon à former les premier et deuxième domaines magnétiques (21, 22), en appliquant un courant électrique le long de la direction longitudinale (x).

12. Procédé selon la revendication précédente comprenant en outre, avant le déplacement de la paroi de domaine (30), une génération d'au moins une paroi de domaine (30) au sein du matériau ferromagnétique.

13. Procédé selon l'une quelconque des deux revendications précédentes comprenant en outre, après dépôt du matériau ferromagnétique sous forme d'un ruban, une formation par lithographie et gravure d'encoches (50) sur des bords opposés du ruban, lesdites encoches (50) étant destinées à fixer la paroi de domaine (30) lors du déplacement de la paroi de domaine.

14. Procédé de réinitialisation d'un dispositif (1) selon l'une quelconque des revendications 1 à 9 comprenant une application d'un courant électrique dans l'aimant (20), le long de la direction longitudinale (x), de façon à déplacer l'au moins une paroi de domaine (30).

15. Procédé de réinitialisation selon la revendication précédente comprenant en outre une génération d'au moins une nouvelle paroi de domaine (30), et une deuxième application d'un courant électrique dans l'aimant (20), le long de la direction longitudinale (x), de façon à déplacer l'au moins une nouvelle paroi de domaine (30) dans une nouvelle position vis-à-vis des premiers et deuxièmes points quantiques (QD1, QD2).

## Patentansprüche

1. Elektronische Vorrichtung (1), die mindestens Folgendes umfasst:
- einen ersten Quantenpunkt (QD1) und einen zweiten Quantenpunkt (QD2), die entlang einer Längsrichtung (x) angeordnet sind, die dazu konfiguriert sind, jeweils zwei entgegengesetzte Spinzustände in Gegenwart eines externen Magnetfeldes (B0) aufzuweisen,
- ein erstes Steuergitter (41), das dem ersten Quantenpunkt (QD1) zugeordnet ist,
- ein zweites Steuergitter (42), das dem zweiten Quantenpunkt (QD2) zugeordnet ist,
- einen Magneten (20), der dazu konfiguriert ist, lokal einen Magnetfeldgradienten zwischen dem ersten und dem zweiten Quantenpunkt (QD1, QD2) derart zu erzeugen, dass der erste und der zweite Quantenpunkt (QD1, QD2) jeweils eine erste und eine zweite voneinander unterschiedliche Resonanzfrequenz aufweisen,
Vorrichtung (1) **dadurch gekennzeichnet, dass** der Magnet (20) mindestens eine erste magnetische Domäne (21) und eine zweite magnetische Domäne (22) umfasst, die entlang der Längsrichtung (x) verteilt und durch mindestens eine Domänenwand (30) getrennt sind, wobei die erste und die zweite magnetische Domäne (21, 22) jeweils eine erste Magnetisierung (A1) und eine zweite Magnetisierung (A2) mit entgegengesetzten Richtungen entlang der Längsrichtung (x) derart aufweisen, dass lokal der Magnetfeldgradient zwischen dem ersten und dem zweiten Quantenpunkt (QD1, QD2) erzeugt wird.

2. Vorrichtung (1) nach dem vorstehenden Anspruch, die N Quantenpunkte (QDi, i = 1...N) umfasst, die entlang der Längsrichtung (x) verteilt sind, und eine Vielzahl von Steuergittern (4i), die den Quantenpunkten (QDi) zugeordnet sind, wobei der Magnet (20) eine Anzahl M erster und zweiter magnetischer Domänen (21, 22) umfasst, die entlang der Längsrichtung (x) verteilt sind, die sich abwechseln und durch M-1 Domänenwände (30) getrennt sind, wobei zwei angrenzende Quantenpunkte (QD1, QD2) um einen Abstand L entlang der Längsrichtung (x) getrennt sind, und wobei eine magnetische Domäne aus der ersten und der zweiten magnetischen Domäne (21, 22) eine Abmessung n.L entlang der Längsrichtung (x) aufweist, wobei n eine natürliche Ganzzahl ungleich null derart ist, dass 1 ≤ n ≤ N-M + 1 ist.

3. Vorrichtung (1) nach einem der vorstehenden Ansprüche, wobei der Magnet (20) die Form eines Bandes aufweist, und wobei die mindestens eine Domänenwand (30) quer zu dem Band (20) durch eine diskontinuierliche Variation des Querschnitts (20) befestigt ist, beispielsweise durch Kerben (50) auf der Ebene der Ränder des Bandes (20).

4. Vorrichtung (1) nach einem der vorstehenden Ansprüche, die außerdem einen Generator von Domänenwänden am Rand des Magneten (20) umfasst.

5. Vorrichtung (1) nach einem der vorstehenden Ansprüche, die N Quantenpunkte (QDi) umfasst, die N Positionen P1 bis PN belegen, die entlang der Längsrichtung (x) verteilt sind, N Gitter (4i), die den N Quantenpunkten (QDi) zugeordnet sind, und wobei der Magnet (20) M magnetische Domänen (21; 22) umfasst, wobei M ≤ N +1 ist, die Magnetisierungen (A1, A2) aufweisen, die einander abwechselnd entgegengesetzt und durch M-1 Domänenwände (30) getrennt sind, wobei die M-1 Wände (30) jeweils M-1 Ebenen quer zu der Längsrichtung (x) umfassen, die jeweils durch eine Position verlaufen, die unter den Positionen P1 bis PN der N Quantenpunkte (QDi) genommen wird.

6. Vorrichtung (1) nach einem der Ansprüche 1 bis 5, die N Quantenpunkte (QDi) umfasst, die regelmäßig um einen Abstand L entlang der Längsrichtung (x) getrennt sind, N Gitter (4i), die den N Quantenpunkten (QDi) zugeordnet sind und wobei der Magnet (20) N magnetische Domänen (21, 22) mit Abmessungen im Wesentlichen gleich L entlang der Längsrichtung (x) umfasst, die Magnetisierungen (A1, A2) einander abwechselnd entgegengesetzt aufweisen und durch N-1 Domänenwände (30) getrennt sind, wobei die N Quantenpunkte (QDi) entlang der Längsrichtung (x) gegenüber und in Entsprechung mit den N magnetischen Domänen (21, 22) verteilt sind, wobei jeder Quantenpunkt entlang der Längsrichtung (x) eine Position belegt, die zu 3/4L gegenüber einem Ende der entsprechenden magnetischen Domäne liegt.

7. Vorrichtung (1) nach einem der Ansprüche 1 bis 5, die N Quantenpunkte (QDi) umfasst, die regelmäßig durch einen Abstand L entlang der Längsrichtung (x) getrennt sind, N Gitter (4i), die den N Quantenpunkten (QDi) zugeordnet sind und wobei der Magnet (20) N magnetische Domänen (21, 22) mit Abmessungen im Wesentlichen gleich L entlang der Längsrichtung (x) umfasst, die Magnetisierungen (A1, A2) einander abwechselnd entgegengesetzt aufweisen und durch N-1 Domänenwände (30) getrennt sind, wobei die N Quantenpunkte (QDi) entlang der Längsrichtung (x) gegenüber und in Entsprechung mit den N magnetischen Domänen (21, 22) verteilt sind, wobei jeder Quantenpunkt entlang der Längsrichtung (x) eine Position belegt, die zu L/2 gegenüber einem Ende der entsprechenden magnetischen Domäne liegt.

8. Vorrichtung nach einem der vorstehenden Ansprüche, die mindestens eine erste Linie (L1) und eine zweite Linie (L2) umfasst, die zueinander parallel und entlang der Längsrichtung (x) ausgerichtet sind, wobei jede Linie (L1, L2) mindestens zwei Quantenpunkte (QD11, QD12, QD21, QD22) und zwei Steuergitter, die jeweils einem der Quantenpunkte zugeordnet sind, umfasst, wobei die Vorrichtung (1) außerdem mindestens einen ersten Magneten (20a) und einen zweiten Magneten (20b) umfasst, die jeweils der ersten und der zweiten Linie (L1, L2) zugeordnet sind, wobei jeder Magnet (20a, 20b) mindestens die erste und die zweite magnetische Domäne (21, 22) umfasst, die entlang der Längsrichtung (x) verteilt und durch eine Domänenwand (30) getrennt sind, wobei die erste und die zweite magnetische Domäne (21, 22) jeweils die erste und die zweite Magnetisierung (A1, A2) mit entgegengesetzter Richtung entlang der Längsrichtung (x) aufweisen, wobei der erste Magnet (20a) parallel zu der ersten Linie (L1) angeordnet ist, und der zweite Magnet (20b) parallel zu der zweiten Linie (L2) derart angeordnet ist, dass lokal ein erster Magnetfeldgradient zwischen dem ersten und dem zweiten Quantenpunkt (QD11, QD12) der ersten Linie (L1) und ein zweiter Magnetfeldgradient zwischen dem ersten und dem zweiten Quantenpunkt (QD21, QD22) der zweiten Linie (L2) erzeugt wird.

9. Vorrichtung (1) nach dem vorstehenden Anspruch, wobei die erste und die zweite Magnetisierung (A1, A2) der ersten und der zweiten magnetischen Domäne (21, 22) des ersten Magneten (20a) jeweils dieselbe Richtung wie die erste und die zweite Magnetisierung (A1, A2) der ersten und zweiten magnetischen Domäne (21, 22) des zweiten Magneten (20b) an denselben Positionen entlang der Längsrichtung (x) entlang der ersten und zweiten Linie (L1, L2) aufweisen.

10. System, das mindestens eine Vorrichtung (1) nach einem der vorstehenden Ansprüche umfasst, wobei das System genommen wird aus: einem Rechner oder einem Quantenbeschleuniger, einem Quantenrouter.

11. Herstellungsverfahren einer Vorrichtung (1) nach einem der Ansprüche 1 bis 9, das mindestens die folgenden Schritte umfasst:
- Bilden des ersten und des zweiten Quantenpunkts (QD1, QD2),
- Bilden des ersten und des zweiten Steuergitters (41, 42), die dem ersten und dem zweiten Quantenpunkt (QD1, QD2) zugeordnet sind,
- Bilden des Magneten (20) unter Durchführen mindestens der folgenden Schritte:
∘ Abscheiden eines ferromagnetischen Materials,
∘ Verlagern der Domänenwand (30) innerhalb des ferromagnetischen Materials derart, dass die erste und die zweite magnetische Domäne (21, 22) gebildet werden, indem ein elektrischer Strom entlang der Längsrichtung (x) angelegt wird.

12. Verfahren nach dem vorstehenden Anspruch, das außerdem vor dem Verlagern der Domänenwand (30) eine Erzeugung mindestens einer Domänenwand (30) innerhalb des ferromagnetischen Materials umfasst.

13. Verfahren nach einem der zwei vorstehenden Ansprüche, das außerdem nach dem Abscheiden des ferromagnetischen Materials in Form eines Bandes ein Bilden durch Lithographie und Ätzen von Kerben (50) auf entgegengesetzten Rändern des Bandes umfasst, wobei die Kerben (50) dazu bestimmt sind, die Domänenwand (30) bei der Verlagerung der Domänenwand zu fixieren.

14. Verfahren zur Rückstellung auf Null einer Vorrichtung (1) nach einem der Ansprüche 1 bis 9, das ein Anlegen eines elektrischen Stroms in dem Magneten (20) entlang der Längsrichtung (x) derart umfasst, dass mindestens eine Domänenwand (30) verlagert wird.

15. Verfahren zur Rückstellung auf Null nach dem vorstehenden Anspruch, das außerdem eine Erzeugung mindestens einer neuen Domänenwand (30) und ein zweites Anlegen eines elektrischen Stroms in dem Magneten (20) entlang der Längsrichtung (x) derart umfasst, dass die mindestens eine neue Domänenwand (30) in eine neue Position in Bezug auf den ersten und den zweiten Quantenpunkt (QD1, QD2) verlagert wird.

## Claims

1. Electronic device (1) comprising at least:
- one first quantum dot (QD1) and one second quantum dot (QD2) disposed along a longitudinal direction (x), configured to each have two opposite spin states in the presence of an external magnetic field (B0),
- one first control gate (4₁) associated with the first quantum dot (QD1),
- one second control gate (4₂) associated with the second quantum dot (QD2),
- one magnet (20) configured to locally generate a magnetic field gradient between the first and second quantum dots (QD1, QD2), such that the first and second quantum dots (QD1, QD2) respectively have first and second resonance frequencies which are different from one another,
the device (1) being **characterised in that** the magnet (20) comprises at least one first magnetic domain (21) and one second magnetic domain (22) distributed along the longitudinal direction (x) and separated by at least one domain wall (30), said first and second magnetic domains (21, 22) respectively have a first magnetisation (A1) and a second magnetisation (A2) of opposite directions in the longitudinal direction (x), so as to locally generate said magnetic field gradient between the first and second quantum dots (QD1, QD2).

2. Device (1) according to the preceding claim comprising N quantum dots (QDi, i = 1...N) distributed along the longitudinal direction (x) and a plurality of control gates (4i) associated with said quantum dots (QDi), wherein the magnet (20) comprises a number M of first and second magnetic domains (21, 22) distributed along the longitudinal direction (x), alternate from one another, and separated by M - 1 domain walls (30), wherein two adjacent quantum dots (QD1, QD2) are separated by a distance L in the longitudinal direction (x), and wherein a magnetic domain taken from among the first and second magnetic domains (21, 22) has a dimension n.L in the longitudinal direction (x), with n a non-zero natural integer such that 1 ≤ n ≤ N - M + 1.

3. Device (1) according to any one of the preceding claims, wherein the magnet (20) is presented in the form of a strip, and wherein the at least one domain wall (30) is transversally fixed to the strip (20) by a discontinuous variation of cross-section of the strip (20), for example, by notches (50) at the edges of the strip (20).

4. Device (1) according to any one of the preceding claims, further comprising a domain wall generator at the border of the magnet (20).

5. Device (1) according to any one of the preceding claims comprising N quantum dots (QDi) occupying N positions P1 to PN distributed along the longitudinal direction (x), N gates (4i) associated with said N quantum dots (QDi), and wherein the magnet (20) comprises M magnetic domains (21, 22), M ≤ N+1, having opposite alternating magnetisations (A1, A2) and separated by M-1 domain walls (30), said M-1 walls (30) respectively comprising M-1 transverse planes in the longitudinal direction (x), each passing through a position taken from among the positions P1 to PN of the N quantum dots (QDi).

6. Device (1) according to any one of claims 1 to 5 comprising N quantum dots (QDi) regularly separated by a distance L in the longitudinal direction (x), N gates (4i) associated with said N quantum dots (QDi), and wherein the magnet (20) comprises N magnetic domains (21, 22) of dimension substantially equal to L in the longitudinal direction (x), having opposite alternating magnetisations (A1, A2) and separated by N-1 domain walls (30), said N quantum dots (QDi) being distributed along the longitudinal direction (x) facing and corresponding to the N magnetic domains (21, 22), each quantum dot occupying, in the longitudinal direction (x), a position located at 3/4L vis-à-vis an end of the corresponding magnetic domain.

7. Device (1) according to any one of claims 1 to 5 comprising N quantum dots (QDi) regularly separated by a distance L in the longitudinal direction (x), N gates (4i) associated with said N quantum dots (QDi), and wherein the magnet (20) comprises N magnetic domains (21, 22) of dimension substantially equal to L in the longitudinal direction (x), having opposite alternating magnetisations (A1, A2) and separated by N-1 domain walls (30), said N quantum dots (QDi) being distributed along the longitudinal direction (x) facing and corresponding to the N magnetic domains (21, 22), each quantum dot occupying, in the longitudinal direction, a position located at L/2 vis-à-vis an end of the corresponding magnetic domain.

8. Device according to any one of the preceding claims, comprising at least one first line (L1) and one second line (L2) parallel to one another and directed in the longitudinal direction (x), each line (L1, L2) comprising at least two quantum dots (QD11, QD12, QD21, QD22) and two control dates, each respectively associated with one of said quantum dots, the device (1) further comprising at least one first magnet (20a) and one second magnet (20b) respectively associated with the first and second lines (L1, L2), each magnet (20a, 20b) comprising at least the first and second magnetic domains (21, 22) distributed along the longitudinal direction (x) and separated by a domain wall (30), said first and second magnetic domains (21, 22) respectively having the first and second magnetisations (A1, A2) of opposite directions in the longitudinal direction (x), the first magnet (20a) being disposed parallel to the first line (L1) and the second magnet (20b) being disposed parallel to the second line (L2), so as to locally generate a first magnetic field gradient between the first and second quantum dots (QD11, QD12) of the first line (L1), and a second magnetic field gradient between the first and second quantum dots (QD21, QD22) of the second line (L2).

9. Device (1) according to the preceding claim, wherein the first and second magnetisations (A1, A2) of the first and second magnetic domains (21, 22) of the first magnet (20a) respectively having the same direction as the first and second magnetisations (A1, A2) of the first and second magnetic domains (21, 22) of the second magnet (20b), at the same positions in the longitudinal direction (x) along the first and second lines (L1, L2).

10. System comprising at least one device (1) according to any one of the preceding claims, the system being taken from among: a computer or a quantum accelerator, a quantum router.

11. Method for producing a device (1) according to any one of claims 1 to 9 comprising at least the following steps:
- Forming the first and second quantum dots (QD1, QD2),
- Forming the first and second control gates (41, 42) associated with said first and second quantum dots (QD1, QD2),
- Forming the magnet (20) by carrying out at least the following steps:
∘ Depositing a ferromagnetic material,
∘ Moving the domain wall (30) within the ferromagnetic material so as to form the first and second magnetic domains (21, 22), by applying an electric current along the longitudinal direction (x).

12. Method according to the preceding claim, further comprising, before the movement of the domain wall (30), a generation of at least one domain wall (30) within the ferromagnetic material.

13. Method according to any one of the two preceding claims further comprising, after deposition of the ferromagnetic material in the form of a strip, a formation by lithography and etching of notches (50) on opposite edges of the strip, said notches (50) being intended to fix the domain wall (30) during the movement of the domain wall.

14. Method for reinitialising a device (1) according to any one of claims 1 to 9 comprising an application of an electric current in the magnet (20), along the longitudinal direction (x), so as to move the at least one domain wall (30).

15. Re-initialisation method according to the preceding claim, further comprising a generation of at least one new domain wall (30), and one second application of an electric current in the magnet (20), along the longitudinal direction (x), so as to move the at least one new domain wall (30) into a new position vis-à-vis the first and second quantum dots (QD1, QD2).
